(19) Europäisches Patentamt
European Patent Office
Office européen des brevets

(11) **EP 2 628 242 B1**

(12) **FASCICULE DE BREVET EUROPEEN**

(45) Date de publication et mention de la délivrance du brevet:
**25.12.2019 Bulletin 2019/52**

(51) Int Cl.:
*H03H 9/00* (2006.01)  *H03H 9/64* (2006.01)
*H03H 9/02* (2006.01)  *H03H 9/56* (2006.01)

(21) Numéro de dépôt: **11767266.7**

(22) Date de dépôt: **11.10.2011**

(86) Numéro de dépôt international:
**PCT/EP2011/067728**

(87) Numéro de publication internationale:
**WO 2012/049174 (19.04.2012 Gazette 2012/16)**

(54) **FILTRE PASSE BANDE À ONDES ACOUSTIQUES COMPRENANT UN GUIDAGE ACOUSTIQUE INTÉGRÉ AVEC CONVERSION D'IMPÉDANCE ET/OU DE MODE**

OBERFLÄCHENSCHALLWELLEN-BANDPASSFILTER MIT INTEGRIERTER AKUSTISCHER FÜHRUNG MIT IMPEDANZ- UND/ODER MODUSUMWANDLUNG

SURFACE ACOUSTIC WAVE BAND-PASS FILTER COMPRISING INTEGRATED ACOUSTIC GUIDING WITH IMPEDANCE AND/OR MODE CONVERSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.10.2010 FR 1058404**

(43) Date de publication de la demande:
**21.08.2013 Bulletin 2013/34**

(73) Titulaire: **Commissariat à l'Énergie Atomique et aux Énergies Alternatives 75015 Paris (FR)**

(72) Inventeurs:
• **GORISSE, Marie F-79180 Chauray (FR)**
• **REINHARDT, Alexandre F-38400 Saint Martin D'heres (FR)**

(74) Mandataire: **Esselin, Sophie et al Marks & Clerk France Conseils en Propriété Industrielle Immeuble Visium 22 avenue Aristide Briand 94117 Arcueil Cedex (FR)**

(56) Documents cités:
GB-A- 2 352 101    US-A1- 2003 155 993
US-A1- 2005 140 465    US-A1- 2005 212 620
US-A1- 2008 246 560    US-A1- 2009 295 505
US-B1- 6 492 759

• **GU K-B ET AL: "Design and Fabrication of 2D Phononic Crystals in Surface Acoustic wave Micro Devices", IEEE MICRO ELECTRO MECHANICAL SYSTEMS, MEMS 2006 ISTANBUL, janvier 2006 (2006-01), pages 686-689, XP010914338,**
• **TSUNG-TSONG WU ET AL: "Band gap materials and micro-phononic devices", IEEE FREQUENCY CONTROL SYMPOSIUM, 2010, 1 juin 2010 (2010-06-01), pages 515-520, XP031738463,**
• **NAI-KUEI KUO ET AL: "Evidence of acoustic wave focusing in a microscale 630 MHz Aluminum Nitride phononic crystal waveguide", IEEE FREQUENCY CONTROL SYMPOSIUM, 2010, 1 juin 2010 (2010-06-01), pages 530-533, XP031738462,**
• **LAUDE V ET AL: "6E-2 Surface Acoustic Wave Trapping in a Periodic Array of High Aspect Ratio Electrodes", IEEE ULTRASONICS SYMPOSIUM, 2006, 1 octobre 2006 (2006-10-01), pages 497-500, XP031076336,**
• **ALEXANDRE REINHARDT ET AL: "Acoustic technologies for advanced RF architectures", IEEE NEWCAS CONFERENCE, 2010, 20 juin 2010 (2010-06-20), pages 161-164, XP031776896,**
• **NAKAMURA K ET AL: "THIN FILM RESONATORS AND FILTERS", INTERNATIONAL SYMPOSIUM ON ACOUSTIC WAVE DEVICES FOR FUTUREMOBILE COMMUNICATION SYSTEMS, 5 mars 2001 (2001-03-05), pages 93-99, XP008048920,**

- **OLSSON R H ET AL: "Microfabricated VHF acoustic crystals and waveguides", SENSORS AND ACTUATORS A: PHYSICAL, ELSEVIER BV, NL, vol. 145-146, 1 July 2008 (2008-07-01), pages 87-93, XP022716420, ISSN: 0924-4247, DOI: 10.1016/J.SNA.2007.10.081 [retrieved on 2007-11-12]**

## Description

Le domaine de l'invention est celui des dispositifs électromécaniques exploitant la propagation d'ondes acoustiques dans des couches piézoélectriques ou électrostrictif en vue de réaliser des fonctions de filtre électrique et d'assurer en plus une isolation électrique entre l'entrée et la sortie du composant.

De tels dispositifs présentent des fréquences de fonctionnement de l'ordre de quelques centaines de MHz à quelques GHz, et sont utilisés dans des circuits de transmission radiofréquence (téléphone portable, liaison radio, échange de données sans fil,...), de traitement du signal ou dans des systèmes de capteurs.

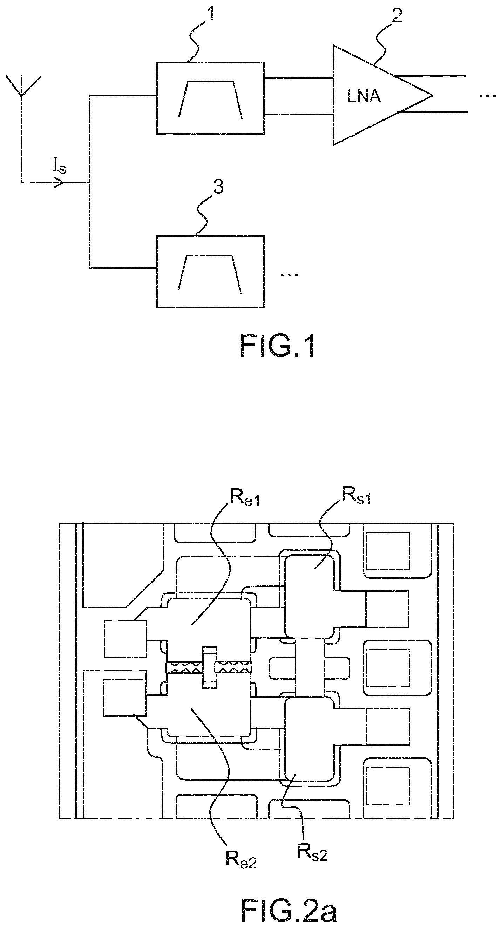

Plus précisément, le domaine de la présente invention concerne l'isolation électrique entre l'entrée et la sortie d'un composant en vue de réaliser principalement une conversion d'impédance et/ou de mode dans des filtres acoustiques, donc des filtres utilisant des résonateurs acoustiques, principalement des résonateurs à ondes de volume (Bulk Acoustic Wave ou BAW). Ces filtres sont localisés à l'étage radiofréquence de systèmes de transmission radio, notamment pour les systèmes de téléphonie mobile. La figure 1 présente un schéma de principe d'un étage RF. Le signal! issu de l'antenne Is est dirigé vers deux voies, filtré sur une première voie dite de réception par un filtre passe-bande 1, puis amplifié par un amplificateur faible bruit 2 (LNA, pour *Low Noise Amplifier*), et bloqué sur une seconde voie en parallèle dite d'émission par un filtre 3 de manière à ne pas interférer avec le signal émis en direction de l'antenne. Le signal issu de l'antenne est par construction référencé à la masse, et donc asymétrique. Par contre, afin de limiter le bruit apporté au signal par l'étage d'amplification, les LNA disposent habituellement d'accès différentiels, où le signal n'est plus référencé à la masse, mais se propage plutôt sous deux versions déphasées de 180° l'une par rapport à l'autre le long des lignes de transmission.

Pour assurer la liaison entre la partie référencée à la masse de la chaine et la partie différentielle, il est possible de passer par un élément externe au filtre, inséré entre filtre et amplificateur, ou entre antenne et filtre, appelé balun (pour *Balanced / Unbalanced*). Les baluns sont des systèmes très coûteux en place et apportant des pertes. Ils sont en effet réalisables en utilisant des sections de ligne de transmission qui devraient présenter des dimensions centimétriques aux fréquences habituellement employées pour la téléphonie mobile (de l'ordre de quelques GHz), ou plus communément en utilisant des enroulements magnétiques proches de transformateurs, donc nécessitant de grandes surfaces (quelques mm$^2$) et présentant des pertes résistives non négligeables.

Il a déjà été proposé des filtres CRF (Coupled Resonator Filter), filtres couplés acoustiquement, permettant la conversion de mode G.G. Fattinger, J. Kaitila, R. Aigner and W. Nessler, Single-to-balanced Filters for Mobile Phones using Coupled Resonator BAW Technology, 2004 IEEE Ultrasonics Symposium, pp. 416-419, car par construction l'entrée et la sortie du filtre sont isolées électriquement : R. Thalhammer, M. M. Handtmann, J. Kaitila, W. Nessler, L. Elbrecht, *Apparatus with acoustically coupled BAW resonators and a method for matching impedances,* brevet US 2009 / 0096549 A1, Avr. 2009

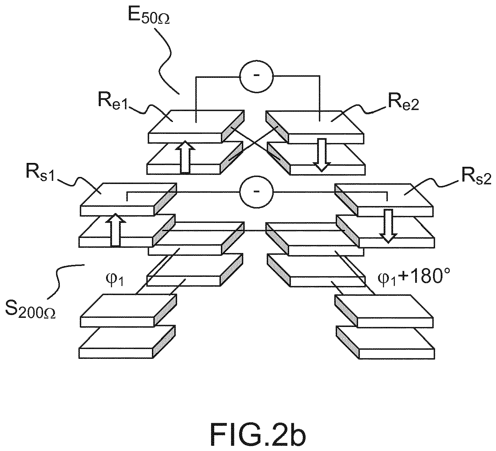

Les figures 2a et 2b représentent un filtre à conversion à la fois de mode et d'impédance en technologie CRF, la figure 2b mettant en évidence les connections électriques des résonateurs. La conversion d'impédance est obtenue par le montage des deux résonateurs d'entrée $R_{e1}$ et $R_{e2}$ et de deux résonateurs de sortie, tête bêche, de manière à apporter un facteur 4 à l'impédance d'entrée du filtre. La réalisation technologique est cependant très lourde, car elle nécessite l'empilement de deux résonateurs l'un sur l'autre et par conséquent une technologie requérant le dépôt d'une quinzaine de couches et une douzaine de niveaux de masques : C. Billard, N. Buffet, A. Reinhardt, G. Parat, S. Joblot and P. Bar, 200mm Manufacturing Solution for Coupled Resonator Filters, Proceedings of the 39th European Solid-State Device Research Conference (ESSDERC 2009), pp. 133-136.

De même il est possible d'empiler des résonateurs $R_1$ et $R_2$ d'épaisseurs différentes M.L. Franck, R.C. Ruby, T. Jamneala, *Bulk Acoustic Resonator Electrical Impedance Transformers,* brevet US 2009 / 0273415 A1, Nov. 2009, comme indiqué dans la figure 3. Ces résonateurs sont couplés acoustiquement par la (ou les) couche(s) $C_c$ situées entre eux. Ils sont empilés au-dessus d'une membrane réalisée au-dessus d'une cavité $C_a$ réalisée à la surface d'un substrat S. La conversion d'impédance est réalisée par la différence d'épaisseurs, les résonateurs inférieur et supérieur présentant, pour une même surface, des valeurs de capacités, et donc d'impédance, différentes. Cette solution pose les mêmes problèmes de fabrication que les CRF, à savoir qu'elle nécessite l'empilement de nombreuses couches et l'utilisation de nombreux niveaux de masques. De plus les épaisseurs sont fixées dans une certaine limite par l'acoustique (les fréquences voulues, la bande passante, les coefficients de couplage des modes utilisés,...), ne permettant pas tous les rapports de conversion voulus.

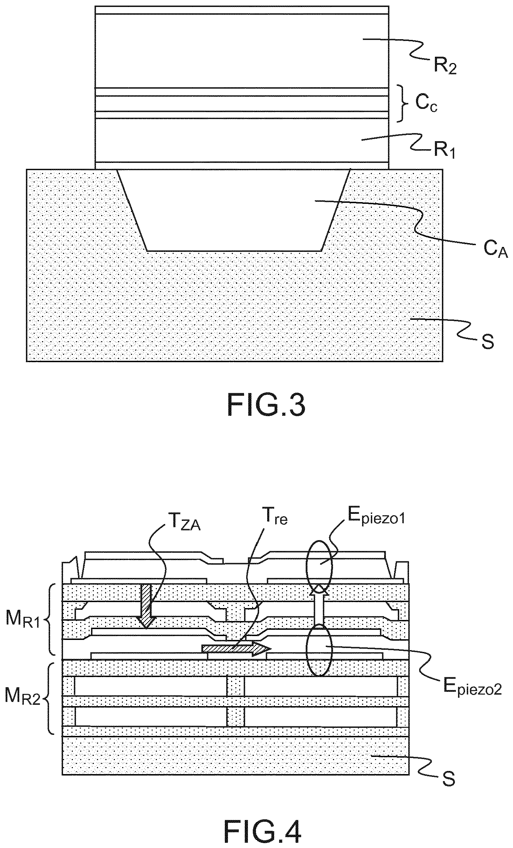

Par ailleurs, afin de fournir un filtre possédant une sélectivité suffisante, il est souvent nécessaire d'utiliser deux sections de filtres qui, pour des raisons de complexité technologique, sont souvent reliées au niveau des résonateurs inférieurs comme représenté en figure 4 et utilisant deux types d'empilements comprenant des matériaux piézoélectriques $E_{piezo1}$ et $E_{piezo2}$, isolés par des structures de miroirs de Bragg $M_{R1}$ et $M_{R2}$, l'ensemble des empilements étant réalisé à la surface d'un substrat S. Les surfaces de ces sections sont alors définies par les impédances respectivement d'entrée et de sortie, tandis que les épaisseurs des résonateurs inférieurs et supérieurs sont définies par des considérations acoustiques, comme précisé précédemment. Ainsi, les deux résonateurs inférieurs ne possèdent-ils pas la même impédance, celle-ci étant définie par la formule

$$Z_{res} = \frac{e_{piezo}}{2\pi\varepsilon_{piezo}S_{res}f_0}, \qquad (1)$$

où $e_{piezo}$ est l'épaisseur de la couche piézoélectrique, $\varepsilon_{piezo}$ la constante diélectrique du matériau piézoélectrique employé, $f_0$ la fréquence centrale du filtre, toutes ces grandeurs étant communes aux résonateurs inférieurs et $S_{res}$ la surface respective de chaque résonateur. Il se crée de ce fait des réflexions électriques internes au filtre qui dégradent sa transmission et donc ses performances.

Dans le contexte de la présente invention, il est connu de la demande de brevet US 2009/295505, une configuration comprenant sur un substrat SOI, un transducteur d'entrée comprenant une couche piézoélectrique et un transducteur de sortie comprenant également une couche piézoélectrique. La couche supérieure de SOI comporte entre les deux couches de matériau piézoélectrique une structure PC, phononique.

Le brevet US 6 492 759 décrit une structure dans laquelle il est prévu une structure d'électrodes disposées autour des électrodes des résonateurs, dont on peut ajuster la masse et qui ne nécessite pas de périodicité d'éléments.

Il est aussi connu de la demande de brevet US 2005/0140465, un résonateur de type FBAR dans lequel est créée une structure de cristal phononique pour éliminer des modes de propagation acoustique transverses.

Il est également connu de l'article « Microfabricated VHF acoustic crystals and waveguides » de Roy.H.Olsson III, Ihab F.El-Kady, Mehmet F.Su, Melanie R.Tuck, James G.Fleming, Science-Direct Sensors and Actuators A 145-146 (2008) 87-93, des procédés de réalisation de cristaux phononiques.

Dans ce contexte, la présente invention a pour objet une solution permettant la conversion d'impédance et/ou la conversion de mode en utilisant un couplage acoustique des résonateurs. Cette conversion est obtenue en assurant une isolation électrique entre l'entrée et la sortie du filtre, l'isolation étant elle-même obtenue par la propagation des ondes acoustiques entre les résonateurs du filtre. Selon l'invention, le guidage desdites ondes permet ainsi une meilleure canalisation des ondes et donc d'utiliser des résonateurs de géométries différentes. La conversion selon l'invention permet ainsi d'éviter de recourir à la complexité technologique d'un filtre CRF, et ce en autorisant une plus large latitude dans les rapports d'impédance qu'il est possible d'attendre tout en limitant les risques de réflexions électriques internes dans le cas de filtres d'ordre élevé.

Plus précisément la présente invention a pour objet un filtre passe bande à ondes acoustiques comprenant au moins un premier résonateur d'entrée à ondes acoustiques présentant une face de sortie et un second résonateur de sortie à ondes acoustiques présentant une face d'entrée, lesdits résonateurs étant couplés acoustiquement entre eux, les faces d'entrée et de sortie étant sensiblement en regard, caractérisé en ce qu'il comprend en outre au moins une première structure de cristal phononique entre lesdits résonateurs d'entrée et de sortie permettant de maîtriser la quantité d'énergie échangée entre lesdits deux résonateurs et une deuxième structure de cristal phononique en périphérie desdits résonateurs de manière à canaliser les ondes acoustiques générées par ledit résonateur d'entrée, vers ledit résonateur de sortie, les résonateurs :

- comportant au moins une couche de matériau piézoélectrique ou de matériau électrostrictif et au moins une électrode ;
- étant des résonateurs à ondes de volume ;
- étant placés côte à côte sur un même substrat ;
- permettant d'assurer une conversion d'impédance et/ou de mode ;

Selon des variantes de l'invention, les faces d'entrée et de sortie respectivement desdits second et premier résonateurs étant parallèles entre elles.

Selon des variantes de l'invention, ladite face de sortie dudit résonateur d'entrée est de dimension différente de celle de ladite face d'entrée dudit résonateur de sortie.

Selon des variantes de l'invention, le filtre comprend un premier ensemble de résonateurs d'entrée et un second ensemble de résonateurs de sortie, une première structure de cristal phononique étant disposée entre ledit premier ensemble et ledit second ensemble.

Selon des variantes de l'invention, le filtre comprend un résonateur d'un desdits ensembles couplé avec deux résonateurs dudit autre ensemble.

Selon des variantes de l'invention, le filtre comprend plus d'un couple de premiers résonateurs d'entrée couplés à des seconds résonateurs de sortie, une première structure de cristal phononique étant disposée entre un premier résonateur d'entrée et un second résonateur de sortie.

Selon des variantes de l'invention, la première structure de cristal phononique est une structure de lentille acoustique.

Selon des variantes de l'invention, la seconde structure de cristal phononique assure une fonction miroir pour lesdites ondes acoustiques.

Selon des variantes de l'invention, la première structure de cristal phononique est une structure de couplage d'ondes acoustiques et le coefficient de transmission des ondes acoustiques des secondes structures de cristal phononique est beaucoup plus faible que celui des premières structures de cristal phononique.

Selon des variantes de l'invention, le filtre comporte au moins un résonateur d'entrée connecté à un premier potentiel (V1) et à la masse, un premier résonateur de sortie connecté à un second potentiel (+V2) et à la masse et un second résonateur de sortie connecté à l'inverse du second potentiel (-V2) et à la masse, de manière à assurer une conversion d'impédance et de modes acoustiques entre le résonateur d'entrée et les résonateurs de sortie.

Selon des variantes de l'invention, les structure(s) de cristal phononique sont situées dans la couche de matériau piézoélectrique ou électrostrictif.

Selon des variantes de l'invention, les structures de cristal phononique comportent des motifs en surface de la couche de matériau piézoélectrique ou électrostrictif.

Selon des variantes de l'invention, les motifs des structures phononiques sont réalisés avec au moins l'un des matériaux suivants : $SiO_2$, SiN, Mo, W, AIN.

Selon des variantes de l'invention, les structures de cristal phononique sont unidimensionnelles ou bidimensionnelles ou encore tridimensionnelles.

Selon des variantes de l'invention, le matériau piézoélectrique est un matériau parmi AIN, $LiNbO_3$, ZnO, PZT, quartz.

Selon des variantes de l'invention, le matériau électrostrictif est un matériau choisi parmi $BaSrTiO_3$, $SrTiO_3$, $BaTiO_3$.

Selon des variantes de l'invention, les structures de cristal phononique comportent des inclusions atomiques et/ou des espèces diffusées.

Selon des variantes de l'invention, les inclusions sont obtenues par implantation d'atomes d'hydrogène.

Selon des variantes de l'invention, les structures de cristal phononique comportent des trous.

Selon des variantes de l'invention, ledit filtre comportant plusieurs premières structures de cristal phononique, certaines desdites premières structures présentent des coefficients d'atténuation des ondes acoustiques différents des autres premières structures.

L'invention sera mieux comprise et d'autres avantages apparaîtront à la lecture de la description qui va suivre donnée à titre non limitatif et grâce aux figures annexées parmi lesquelles :

- la figure 1 illustre un schéma de principe d'un étage radiofréquence de système de transmission ou réception ;
- les figures 2a et 2b illustrent le schéma d'un filtre à conversion d'impédance et de modes selon l'art connu ainsi que les réseaux de connexion mis en jeu ;
- la figure 3 illustre un filtre de type FBAR à conversion d'impédance selon l'art connu utilisant des résonateurs empilés ;
- la figure 4 illustre un filtre de type CRF à conversion d'impédance selon l'art connu utilisant quatre résonateurs ;
- la figure 5 illustre une vue de dessus d'un filtre à conversion d'impédance selon l'invention comportant deux structures de cristal phononique dont une assure une fonction de guidage et l'autre une fonction de couplage ;
- la figure 6 illustre une vue de dessus d'un filtre à conversion d'impédance selon l'invention comportant plusieurs résonateurs d'entrée et de sortie et plusieurs structures de cristal phononique ;

- la figure 7 illustre une vue de dessus d'un filtre à conversion d'impédance et de mode selon l'invention comportant un résonateur d'entrée et deux résonateurs de sortie vers lesquels sont guidées les ondes acoustiques ;
- la figure 8 illustre l'admittance de résonateurs de type BAW utilisés dans un filtre de l'invention ;
- les figures 9a, 9b et 9c illustrent des exemples de configurations de résonateurs et de structures de cristal phononique pouvant être utilisés dans un exemple de filtre selon l'invention ;
- les figures 10a à 10e illustrent les différentes étapes de réalisation d'un premier exemple selon l'invention en vue en coupe et de dessus ;
- les figures 11a à 11f illustrent les différentes étapes de réalisation d'un second exemple selon l'invention en vue en coupe et de dessus ;
- les figures 12a à 12f illustrent les différentes étapes de réalisation d'un troisième exemple selon l'invention en vue en coupe et de dessus.

Pour réaliser le filtre de la présente invention, il est proposé de venir placer des résonateurs acoustiques d'entrée et de sortie de type BAW (Bulk Acoustic Wave) tel que des SMR (Solidly Mounted Resonator) ou FBAR (Film Bulk Acoustic Resonator) ou encore HBAR (High-overtone Bulk Acoustic Resonator), côte à côte sur un même substrat.

De façon générale, on entend par résonateur acoustique, une cavité acoustique résonante qui comporte ou non une ou plusieurs électrodes. Lorsqu'une cavité résonante n'est pas associée à une électrode, on enlève une ou plusieurs inclusion(s) dans le cristal phononique à des endroits déterminés pour générer les ondes acoustiques désirées.

Pour réaliser une fonction de filtre et assurer une conversion d'impédance et/ou de mode acoustique, on peut avantageusement coupler acoustiquement deux résonateurs de tailles différentes. Le couplage acoustique réalisé ainsi n'entraine alors pas d'effet de réflexions électriques internes et les performances du filtre obtenu s'en trouvent améliorées. Il est par ailleurs proposé d'introduire entre au moins un résonateur d'entrée et un résonateur de sortie, une structure de cristal phononique, afin de maîtriser la quantité d'énergie échangée entre les deux résonateurs, et par conséquent la largeur de bande du composant final.

La conversion d'impédance permet de fournir par exemple un composant ayant une impédance caractéristique en entrée différente de celle de l'impédance de sortie. Un exemple classique est un filtre avec une entrée adaptée à 50 Ohms et une sortie adaptée à 200 Ohms (ces adaptations étant réglées par les dimensions des résonateurs d'entrée et de sortie : la surface pour des résonateurs BAW ou la longueur et le nombre de peignes interdigités pour les résonateurs à ondes de Lamb ou SAW).

Par ailleurs, la conversion de mode peut consister à présenter un résonateur en entrée, dont une des électrodes est référencée à la masse, et l'autre au signal d'entrée. En sortie, on dispose ainsi de deux résonateurs, soit déphasés acoustiquement de 180°, soit connectés tête bêche, de manière à générer deux signaux de signes opposés dans le circuit aval.

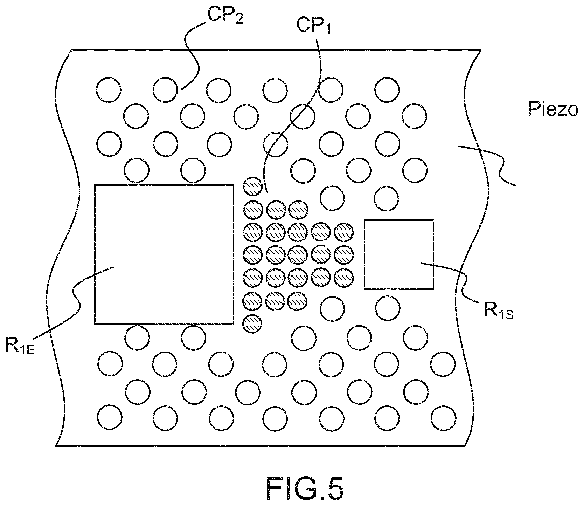

Selon une première variante d'invention, on place un cristal phononique qui couple les résonateurs entre eux et on guide les ondes à l'aide d'un autre cristal phononique conçu pour réfléchir quasi totalement les ondes et ainsi confiner ces dernières dans ou entre les résonateurs, comme illustré en figure 5. Typiquement le résonateur d'entrée $R_{1E}$ et le résonateur de sortie $R_{1S}$ n'ont pas les mêmes dimensions et donc les mêmes impédances (dépendantes de leurs dimensions). Une première structure de cristal phononique $CP_1$ est intégrée entre les deuxdits résonateurs $R_{1E}$ et $R_{1S}$, au niveau de la couche de matériau piézoélectrique $P_{iezo}$. Une seconde structure de cristal phononique $CP_2$ est prévue en périphérie des résonateurs d'entrée et de sortie, de manière à pouvoir confiner les ondes acoustiques, cette seconde structure assurant un effet miroir vis-à-vis des ondes acoustiques. Le cristal CP1 doit présenter un coefficient de transmission déterminé par la bande passante recherchée et le cristal phononique CP2 doit présenter un coefficient de réflexion maximal.

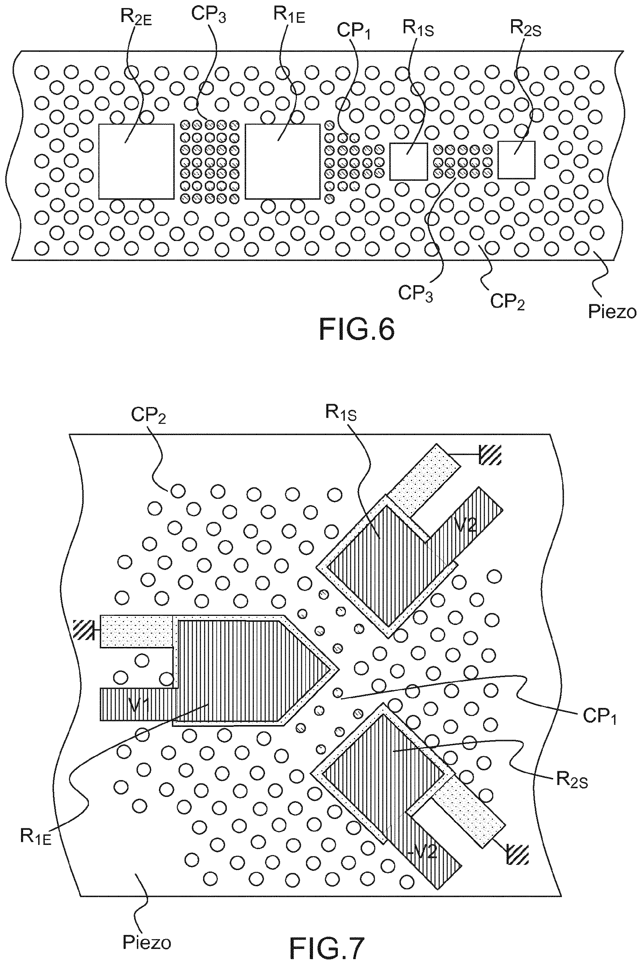

Selon une troisième variante de l'invention, le filtre peut comprendre avantageusement des résonateurs couplés. L'ajout de résonateurs supplémentaires permet d'améliorer la sélectivité du filtre. La figure 6 illustre à ce titre une configuration comportant deux premiers résonateurs $R_{1E}$ et $R_{2E}$, et de deux seconds résonateurs $R_{1S}$ et $R_{2S}$, chaque résonateur étant séparé d'un résonateur adjacent par une structure de cristal phononique : une première structure de conversion $CP_1$ entre les deux résonateurs $R_{1E}$ et $R_{1S}$, une seconde structure de cristal phononique guidante $CP_2$ et des troisièmes structures de cristal phononique $CP_3$ permettant d'améliorer la sélectivité du filtre.

La présente invention permet d'envisager la conversion d'impédance et de mode en même temps. En effet, il est possible de guider les ondes vers deux résonateurs plutôt qu'un seul. Selon la technologie utilisée, il est aussi possible de connecter électriquement les deux résonateurs de sortie, en direct ou en inversé comme illustré plus précisément en figure 7 qui montre les potentiels auxquels sont connectés les résonateurs d'entrée et de sortie. Un résonateur d'entrée $R_{1E}$ est prévu connecté d'une part à un premier potentiel V1 et d'autre part à la masse. Au niveau de la sortie, il est prévu selon cette variante, un premier résonateur de sortie $R_{1S}$ et un second résonateur de sortie $R_{2S}$, le premier résonateur de sortie étant connecté à la masse et à un second potentiel V2, le second résonateur de sortie étant connecté en différentiel à la masse et à un potentiel -V2.

Avantageusement les géométries des résonateurs sont déterminées afin de mieux diriger les ondes latérales en direction des résonateurs de sortie.

Il est rappelé que quelle que soit la variante de l'invention, il est possible d'utiliser des cristaux phononiques à une, deux ou trois dimensions indifféremment, tant que la première structure de cristal phononique utilisée assure sa fonction de miroir ou lentille acoustique.

La présente invention permet ainsi de réaliser la conversion d'impédance sans la conversion de mode. Elle est aussi moins coûteuse en place (et probablement en pertes) que la technique par balun (couplage électrique). Par rapport aux CRF, la technologie de fabrication est fortement simplifiée. En effet on peut réaliser de tels dispositifs avec seulement quatre niveaux de masques.

Il est à noter que dans le cadre de la présente invention, et ce en différentiation avec l'art antérieur, il est notamment proposé d'exploiter des variations de surface des résonateurs et non plus des variations d'épaisseurs, paramètre plus facile à maîtriser.

Nous allons décrire ci-après des exemples de réalisation de filtre selon la présente invention.

Premier exemple de filtre selon l'invention :

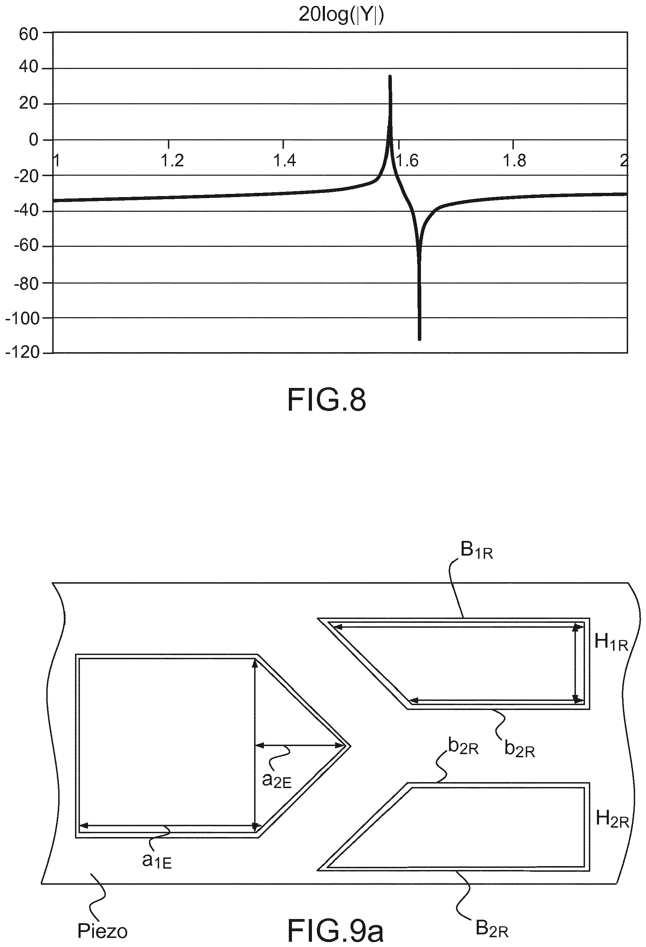

Selon cet exemple, le filtre comporte des résonateurs BAW composés d'une couche de 2 $\mu$m de nitrure d'aluminium (AlN) entre deux électrodes en molybdène (Mo) d'une épaisseur chacune de 200 nm. Cette couche d'AlN est suspendue sur un substrat conventionnel de silicium permettant de réaliser plus précisément des résonateurs de type FBAR (Film Bulk Acoustic Resonator). La figure 8 illustre l'admittance de tels résonateurs calculés à partir d'un modèle 1D basé sur les équations de Mason, montrant une résonance aux alentours de 1.6 GHz.

En cherchant à avoir une impédance de 50 $\Omega$ pour le résonateur d'entrée et de 100 $\Omega$ pour les résonateurs de sortie, on peut calculer les surfaces des résonateurs en se basant sur l'équation suivante :

$$Z = \frac{1}{C\omega}$$

Avec : Z l'impédance du résonateur
C la capacité du résonateur
$\omega$ la pulsation de résonance du résonateur

On sait par ailleurs que :

$$\omega = 2\pi f \text{ et } C = \frac{\varepsilon S}{e}$$

Avec : f la fréquence de résonance (soit dans le cas présent : 1.6 GHz)

ε la permittivité du matériau (soit dans le cas présent de l'AIN, 8,26.10$^{-8}$)

S la surface du résonateur

e l'épaisseur de la couche piézoélectrique (ici 2 μm)

Pour avoir une impédance de 50 Ω, il convient donc d'avoir une capacité C = 2 pF et par voie de conséquence une surface S = 48 600 μm². De même pour obtenir une impédance de 100 Ω on cherche à obtenir les mêmes caractéristiques divisées par 2, soit une capacité C = 1 pF et une surface S = 24 300 μm². La figure 9a illustre un exemple de configuration permettant d'obtenir ces paramètres physiques et ce avec les dimensions suivantes :

- pour le résonateur d'entrée : les cotes suivantes : $a_{1E}$ =180 μm et $a_{2E}$ = 90 μm ;
- pour les résonateurs de sortie : les cotes suivantes : $B_{1R}$=$B_{2R}$= 270 μm, $b_{1R}$ = $b_{2R}$ = 180 μm et $H_{1R}$=$H_{2R}$=90 μm.

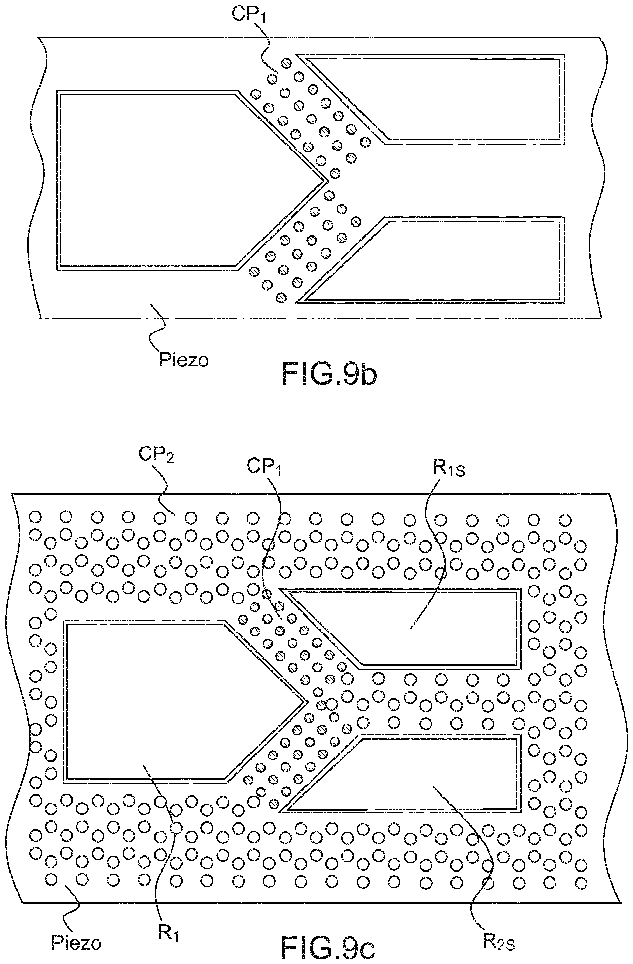

Pour réaliser la structure de cristal phononique $CP_1$ comme illustré sur la figure 9b, on peut réaliser une structure comportant des trous cylindriques dans une membrane en AIN. Les trous sont organisés selon une maille carrée avec un paramètre de maille a = 2.22 μm et le diamètre des trous est de : d = 1.28 μm, l'épaisseur d'AIN étant 2 μm.

Dans ce cas le cristal phononique présente une bande d'arrêt entre 1.57 et 1.64 GHz.

Avantageusement, ce filtre peut comprendre une seconde structure $CP_2$ de cristal phononique comme illustré en figure 9c, et ce afin d'obtenir une meilleure réflexion autour des résonateurs d'entrée et de sortie pour éviter les pertes. Cette seconde structure peut être notamment réalisée en opérant des trous cylindriques dans l'AIN, selon une organisation hexagonale en nid d'abeille. Avec un paramètre de maille de 1,43 μm et un rayon de 0,69 μm et en conservant une épaisseur de 2 μm, on obtient une bande d'arrêt entre 1,34 et 1,83 GHz.

Il est également possible avec cet exemple de filtre, de réaliser une conversion de mode en réalisant des connections électriques entre les électrodes inférieures et supérieures des deux résonateurs de droite.

Premier exemple de procédé de fabrication de filtre selon l'invention :

Le premier exemple est un filtre composé de résonateurs SMR (Solidly Mounted Resonators) sur miroir de Bragg couplés par une lentille acoustique consistant en un cristal phononique à deux dimensions constitué de plots de silice disposés dans l'espace entre les résonateurs au-dessus de la couche piézoélectrique. On pourrait aussi placer les plots de silice en-dessous et avantageusement au-dessus et en-dessous de la couche piézoélectrique.

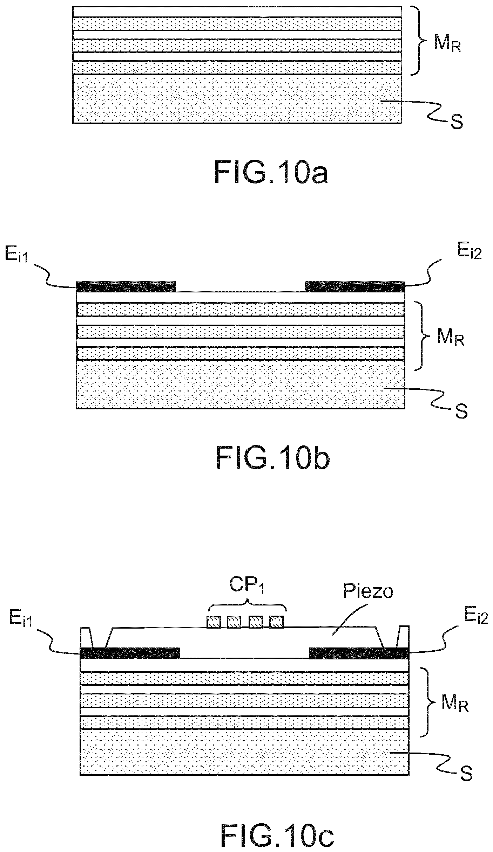

Comme illustré sur la figure 10a, à partir d'un substrat de silicium S, on procède à une opération d'oxydation thermique dudit substrat en SiO₂ sur une épaisseur de 1μm, puis on procède à des dépôts successifs de :

- nitrure de silicium SiN sur une épaisseur de l'ordre de 0.8 μm ;
- oxycarbure de silicium ou silicium poreux SiOC sur une épaisseur d'environ 1 μm ;
- SiN sur une épaisseur d'environ 0.5 μm ;
- SiOC sur une épaisseur d'environ 1 μm ;
- SiN sur une épaisseur d'environ 0.5 μm et
- SiO₂ sur une épaisseur d'environ 0.6 μm de manière à définir une structure de miroir de Bragg $M_R$.

La figure 10b illustre la formation des deux électrodes inférieures $E_{i1}$ et $E_{i2}$ par le dépôt d'une couche de molybdène Mo sur une épaisseur de 0.3 μm puis par lithographie, gravure et retrait de résine appelé « stripping ».

La figure 10c illustre la formation du cristal phononique à la surface du matériau piézoélectrique $P_{iezo}$, grâce aux opérations successives suivantes :

- le dépôt de la couche de matériau piézoélectrique $P_{iezo}$ en AIN sur une épaisseur de 1,7 μm ;
- le dépôt d'une couche en SiO₂ d'épaisseur de l'ordre de 0,5 μm permettant la réalisation de cristal phononique $CP_1$, suivie d'une étape de lithographie, de gravure et du retrait local de la couche de SiO₂ ;
- la gravure et le retrait local de la couche d'AIN pour ouvrir les reprises de contact.

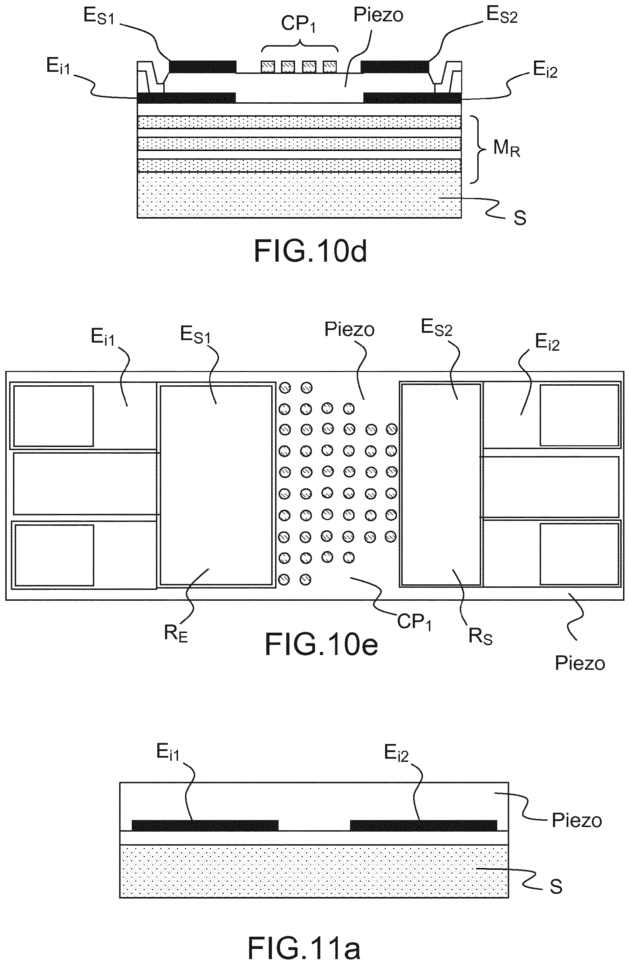

La figure 10d illustre la réalisation des électrodes supérieures $E_{s1}$ et $E_{s2}$ par le dépôt d'une couche de molybdène Mo sur une épaisseur de 0.3 μm puis par lithographie, gravure et « stripping ».

Il est ainsi nécessaire d'avoir quatre niveaux de masques. Le cristal phononique pourrait aussi être constitué de plots de molybdène pour éviter quelques étapes technologiques, mais il faudrait alors faire attention à ce qu'il n'y ait pas de couplage électrique entre les plots métalliques et les résonateurs.

La figure 10e illustre une vue de dessus de cet exemple de filtre, les électrodes $E_{i1}$ et $E_{s1}$ définissant un résonateur d'entrée $R_E$ et les électrodes $E_{i2}$ et $E_{s2}$ définissant un résonateur de sortie $R_S$.

Une variante du premier exemple consiste à réaliser la conversion d'impédance en jouant conjointement sur la surface et l'épaisseur des résonateurs de manière à limiter l'encombrement. Par exemple, en diminuant l'épaisseur de la couche piézoélectrique, la surface nécessaire pour parvenir à une impédance donnée serait plus faible, ce qui induirait une minimisation de la surface occupée par le composant. Cette diminution peut se faire par l'insertion d'étapes de lithographie, gravure de l'AIN et « stripping » entre le dépôt d'AIN et la gravure des accès à l'électrode inférieure.

Second exemple de procédé de fabrication de filtre selon l'invention :

Selon cet exemple, le filtre permet la conversion d'impédance et de mode, avec une sortie branchée en anticroisement. Les résonateurs sont couplés par un cristal phononique à deux dimensions constitué d'inclusions cylindriques d'air (trous) dans une membrane en nitrure d'aluminium (AlN) et réalisé en suivant le procédé développé par l'équipe de G. Piazza : N.K. Kuo, C.J. Zuo, G. Piazza, Demonstration of Inverse Acoustic Band Gap Structures in AlN and Integration with Piezoelectric Contour Mode Wideband Transducers, 2009 Solid-State Sensors, Actuators and Microsystems symposium, pp.10-13, 2009, N. Sinha, R. Mahameed, C. Zuo, M.B. Pisani, C.R. Perez and G. Piazza, Dual-beam actuation of piezoelectric AlN RF MEMS switches monolithically integrated with AlN contour-mode resonators, Solid-State Sensors, Actuators and Microsystems Workshop, Hilton Head Island, pp. 22-25, June 1-5, 2008.

Comme illustré sur la figure 11a, à partir d'un substrat de silicium S, typiquement d'épaisseur de l'ordre de 700 $\mu$m, on réalise un dépôt « Low Strees Nitride » (LSN) d'épaisseur de l'ordre de 300 nm. On réalise à la surface, un dépôt métallique de platine de 200 nm d'épaisseur, et par lithographie et procédé lift-off, on vient définir la géométrie des électrodes inférieures des résonateurs : $E_{i1}$ et $E_{i2}$. On procède alors au dépôt de la couche de matériau piézoélectrique $P_{iezo}$ en nitrure d'aluminium sur une épaisseur d'environ 2 $\mu$m.

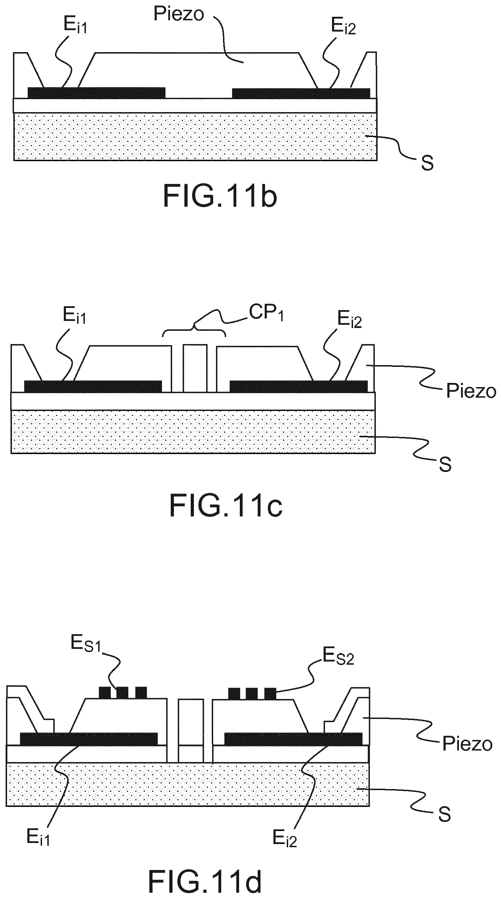

On procède alors à une opération de gravure humide de la couche de matériau piézoélectrique, l'AlN, par du KOH afin de définir les accès aux électrodes inférieures, comme illustré en figure 11b.

On réalise ensuite les structures de cristal phononique par gravure sèche de l'AlN comme représenté en figure 11c.

On procède alors à la réalisation des électrodes supérieures $E_{S1}$ et $E_{S2}$ comme illustré en figure 11d par dépôt d'une couche de platine d'environ 200 nm d'épaisseur, procédé de lithographie et procédé lift-off.

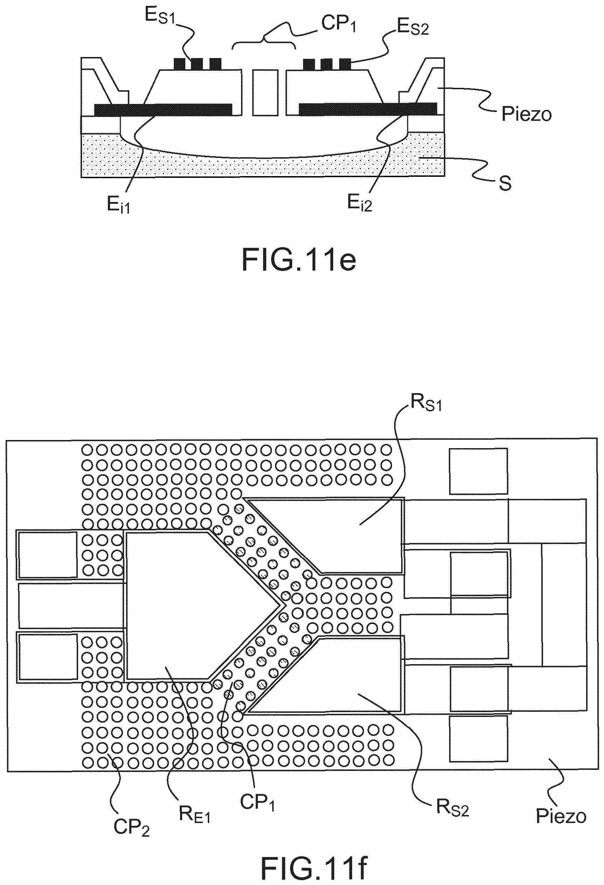

On réalise enfin la libération de la membrane pour définir des résonateurs de type FBAR, par attaque au difluorure de xénon (XeF$_2$), comme illustré en figure 11e.

La figure 11f illustre une vue de dessus du filtre ainsi réalisé et des structures de résonateurs définies par la géométrie des électrodes : un résonateur d'entrée $R_{E1}$ et deux résonateurs de sortie $R_{S1}$ et $R_{S2}$.

Troisième exemple de procédé de fabrication de filtre selon l'invention :

Le troisième exemple est un filtre à conversion d'impédance constitué de résonateurs FBAR réalisés sur une couche mince d'oxyde de zinc (ZnO). La propagation des ondes est réalisée dans une membrane en silicium. Les cristaux phononiques sont constitués de trous d'air dans la membrane en silicium. Le procédé est basé sur le procédé de réalisation de cristaux phononiques développé par Mohammadi : S. Mohammadi, A.A. Eftekhar, A. Adibi, brevet US 2009/0295505 A1, Dec. 2009.

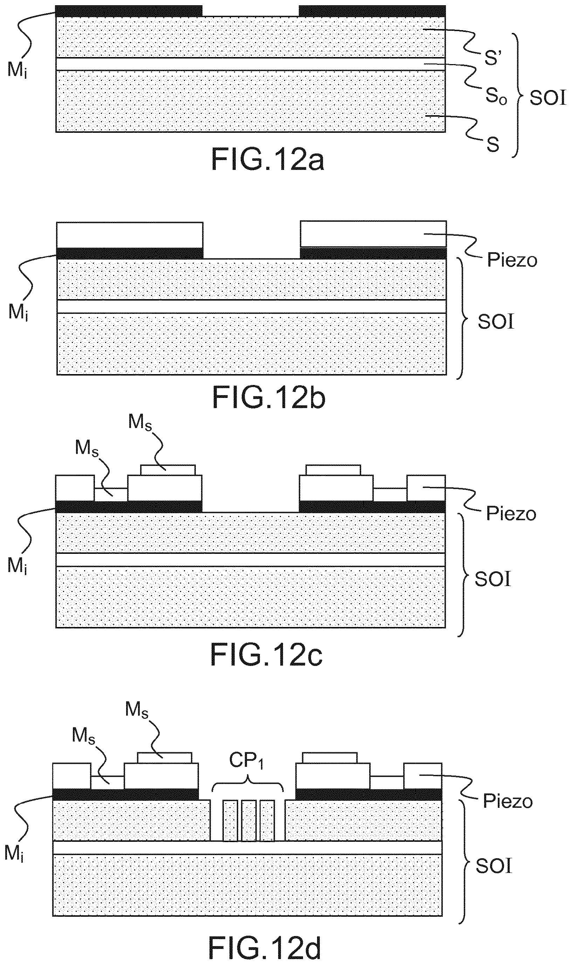

Selon une première étape, à partir d'un substrat SOI (Silicon On Insulator) composé d'un substrat en silicium S comprenant une couche en SiO2, $S_0$ enterrée et donc recouverte d'une couche de silicium S', d'épaisseur de Si de 15 $\mu$m, on procède au dépôt d'une couche $M_i$, d'or de 100 nm d'épaisseur et on définit dans cette couche les électrodes inférieures des résonateurs par procédé de lithographie, comme illustré en figure 12a.

Dans une seconde étape, on procède au dépôt d'une couche de matériau piézoélectrique $P_{iézo}$ en ZnO d'un micron d'épaisseur, sur laquelle on réalise par lithographie, gravure et «stripping », la définition de motifs comme illustré en figure 12b.

Dans une troisième étape, on vient déposer une seconde couche de métallisation $M_S$ d'aluminium de 200 nm d'épaisseur et l'on définit les motifs d'électrodes supérieures par lithographie, comme illustré en figure 12c.

On vient réaliser les structures de cristal phononique $CP_1$ et $CP_2$, au sein du silicium par lithographie, gravure et stripping, comme illustré en figure 12d.

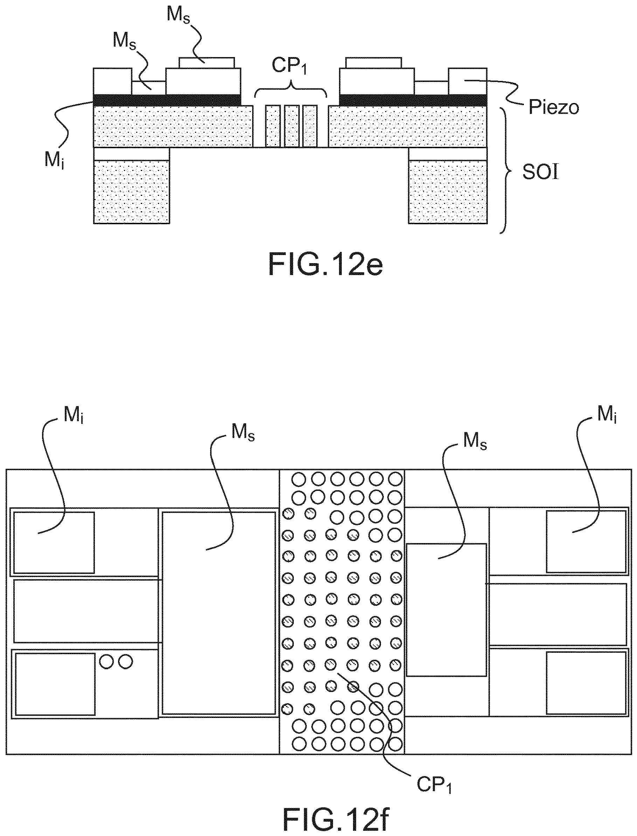

On procède enfin à la libération en face arrière de la membrane afin de réaliser un filtre de type FBAR, par un procédé de gravure pouvant avantageusement être un procédé de type DRIE « Deep Reactive Ionic Etching », comme illustré en figure 12e.

La figure 12f illustre une vue de dessus d'un tel filtre FBAR, montrant les différentes structures de cristal phononiques $CP_1$ et $CP_2$, réalisées lors de l'étape précédente.

**Revendications**

1. Filtre passe bande à ondes acoustiques comprenant au moins un premier résonateur d'entrée ($R_{1E}$) à ondes acoustiques présentant une face de sortie et un second résonateur de sortie ($R_{2S}$) à ondes acoustiques présentant une face d'entrée, lesdits résonateurs étant couplés acoustiquement entre eux, les faces d'entrée et de sortie étant sensiblement en regard, **caractérisé en ce qu'**il comprend en outre au moins une première structure de cristal phononique ($CP_1$) entre lesdits résonateurs d'entrée et de sortie permettant de maîtriser la quantité d'énergie échangée entre lesdits deux résonateurs et une deuxième structure de cristal phononique ($CP_2$) en périphérie desdits résonateurs de manière à canaliser les ondes acoustiques générées par ledit résonateur d'entrée, vers ledit résonateur de sortie, les résonateurs :

   - comportant au moins une couche de matériau piézoélectrique ($P_{iezo}$) ou de matériau électrostrictif et au moins une électrode ;
   - étant des résonateurs à ondes de volume ;

- étant placés côte à côte sur un même substrat ;
- permettant d'assurer une conversion d'impédance et/ou de mode ;

**2.** Filtre passe bande selon la revendication 1, **caractérisé en ce que** les faces d'entrée et de sortie respectivement desdits second et premier résonateurs étant parallèles entre elles.

**3.** Filtre passe bande à ondes acoustiques selon l'une des revendications 1 ou 2, **caractérisé en ce que** ladite face de sortie dudit résonateur d'entrée est de dimension différente de celle de ladite face d'entrée dudit résonateur de sortie.

**4.** Filtre passe bande à ondes acoustiques selon l'une des revendications 1 à 3, **caractérisé en ce qu'**il comprend un premier ensemble de résonateurs ($R_{iE}$) d'entrée et un second ensemble de résonateurs de sortie ($R_{iS}$), une première structure de cristal phononique ($CP_1$) étant disposée entre ledit premier ensemble et ledit second ensemble.

**5.** Filtre passe bande à ondes acoustiques selon la revendication 4, **caractérisé en ce qu'**il comprend un résonateur d'un desdits ensembles couplé avec deux résonateurs dudit autre ensemble.

**6.** Filtre passe bande à ondes acoustiques selon l'une des revendications 1 à 4, **caractérisé en ce qu'**il comprend plus d'un couple de premiers résonateurs d'entrée couplés à des seconds résonateurs de sortie, une première structure de cristal phononique ($CP_1$) étant disposée entre un premier résonateur d'entrée et un second résonateur de sortie.

**7.** Filtre passe bande à ondes acoustiques selon l'une des revendications 3 à 6, **caractérisé en ce que** la première structure de cristal phononique ($CP_1$) est une structure de lentille acoustique.

**8.** Filtre passe bande à ondes acoustiques selon l'une des revendications 1 à 7, **caractérisé en ce que** la seconde structure de cristal phononique ($CP_2$) assure une fonction miroir pour lesdites ondes acoustiques.

**9.** Filtre passe bande à ondes acoustiques selon l'une des revendications précédentes, **caractérisé en ce que** la première structure de cristal phononique est une structure de couplage d'ondes acoustiques et le coefficient de transmission des ondes acoustiques des secondes structures de cristal phononique est beaucoup plus faible que celui des premières structures de cristal phononique.

**10.** Filtre passe bande à ondes acoustiques selon l'une des revendications précédentes, **caractérisé en ce**

**qu'**il comporte au moins un résonateur d'entrée connecté à un premier potentiel (V1) et à la masse, un premier résonateur de sortie connecté à un second potentiel (+V2) et à la masse et un second résonateur de sortie connecté à l'inverse du second potentiel (-V2) et à la masse, de manière à assurer une conversion d'impédance et de modes acoustiques entre le résonateur d'entrée et les résonateurs de sortie.

**11.** Filtre passe bande à ondes acoustiques selon l'une des revendications 1 à 10, **caractérisé en ce que** les structures de cristal phononique sont situées dans la couche de matériau piézoélectrique ou électrostrictif.

**12.** Filtre passe bande à ondes acoustiques selon l'une des revendications 1 à 11, **caractérisé en ce que** les structures de cristal phononique ($CP_1$, $CP_2$) comportent des motifs en surface de la couche de matériau piézoélectrique ou électrostrictif.

**13.** Filtre passe bande à ondes acoustiques selon la revendication 12, **caractérisé en ce que** les motifs des structures phononiques (CP1 ou CP2) sont réalisés avec au moins l'un des matériaux suivants : $SiO_2$, SiN, Mo, W, AIN.

**14.** Filtre passe bande à ondes acoustiques selon l'une des revendications 1 à 13, **caractérisé en ce que** les structures de cristal phononique sont unidimensionnelles ou bidimensionnelles ou encore tridimensionnelles.

**15.** Filtre passe bande à ondes acoustiques selon l'une des revendications 1 à 14, **caractérisé en ce que** le matériau piézoélectrique est un matériau parmi AIN, $LiNbO_3$, ZnO, PZT, quartz.

**16.** Filtre passe bande à ondes acoustiques selon l'une des revendications 1 à 14, **caractérisé en ce que** le matériau électrostrictif est un matériau choisi parmi $BaSrTiO_3$, $SrTiO_3$, $BaTiO_3$.

**17.** Filtre passe bande à ondes acoustiques selon l'une des revendications précédentes, **caractérisé en ce que** les structures de cristal phononique comportent des inclusions atomiques et/ou des espèces diffusées.

**18.** Filtre passe bande à ondes acoustiques selon la revendication 17, **caractérisé en ce que** les inclusions sont obtenues par implantation d'atomes d'hydrogène,

**19.** Filtre passe bande à ondes acoustiques selon l'une des revendications précédentes, **caractérisé en ce que** les structures de cristal phononique comportent des trous.

20. Filtre passe bande à ondes acoustiques selon l'une des revendications 1 à 19, **caractérisé en ce que**, ledit filtre comportant plusieurs premières structures de cristal phononique, certaines desdites premières structures (CP$_1$) présentent des coefficients d'atténuation des ondes acoustiques différents des autres premières structures.

**Patentansprüche**

1. Schallwellen-Bandpassfilter, das mindestens einen ersten Schallwellen-Eingangsresonator (R$_{1E}$) mit einer Austrittsfläche und einen zweiten Schallwellen-Ausgangsresonator (R$_{2S}$) mit einer Eintrittsfläche umfasst, wobei die Resonatoren akustisch miteinander gekoppelt sind, wobei die Ein- und Austrittsflächen einander im Wesentlichen gegenüber liegen, **dadurch gekennzeichnet, dass** es ferner mindestens eine erste phononische Kristallstruktur (CP$_1$) zwischen den Ein- und Ausgangsresonatoren, die es zulässt, die zwischen den beiden Resonatoren ausgetauschte Energiemenge zu kontrollieren, und eine zweite phononische Kristallstruktur (CP$_2$) an der Peripherie der Resonatoren umfasst, um die durch den Eingangsresonator erzeugten Schallwellen in Richtung des Ausgangsresonators zu kanalisieren, wobei die Resonatoren:

   - mindestens eine piezoelektrische Materialschicht (P$_{iezo}$) oder eine elektrostriktive Materialschicht und mindestens eine Elektrode umfassen;
   - Volumenwellenresonatoren sind;
   - Seite an Seite auf einem selben Substrat platziert sind;
   - die Gewährleistung einer Impedanz- und/oder Modenkonvertierung zulassen.

2. Bandpassfilter nach Anspruch 1, **dadurch gekennzeichnet, dass** die Ein- und Austrittsflächen des jeweiligen zweiten und ersten Resonators parallel zueinander sind.

3. Schallwellen-Bandpassfilter nach einem der Ansprüche 1 oder 2, **dadurch gekennzeichnet, dass** die Austrittsfläche des Eingangsresonators eine andere Abmessung hat als die der Eintrittsfläche des Ausgangsresonators.

4. Schallwellen-Bandpassfilter nach einem der Ansprüche 1 bis 3, **dadurch gekennzeichnet, dass** es eine erste Gruppe von Eingangsresonatoren (R$_{iE}$) und eine zweite Gruppe von Ausgangsresonatoren (R$_{iS}$) umfasst, wobei eine erste phononische Kristallstruktur (CP$_1$) zwischen der ersten Gruppe und der zweiten Gruppe angeordnet ist.

5. Schallwellen-Bandpassfilter nach Anspruch 4, **dadurch gekennzeichnet, dass** es einen Resonator von einer der Gruppen umfasst, gekoppelt mit zwei Resonatoren der anderen Gruppe.

6. Schallwellen-Bandpassfilter nach einem der Ansprüche 1 bis 4, **dadurch gekennzeichnet, dass** es mehr als ein Paar erster Eingangsresonatoren gekoppelt mit zweiten Ausgangsresonatoren gibt, wobei eine erste phononische Kristallstruktur (CP$_1$) zwischen einem ersten Eingangsresonator und einem zweiten Ausgangsresonator angeordnet ist.

7. Schallwellen-Bandpassfilter nach einem der Ansprüche 3 bis 6, **dadurch gekennzeichnet, dass** die erste phononische Kristallstruktur (CP$_1$) eine akustische Linsenstruktur ist.

8. Schallwellen-Bandpassfilter nach einem der Ansprüche 1 bis 7, **dadurch gekennzeichnet, dass** die zweite phononische Kristallstruktur (CP$_2$) eine Spiegelfunktion für die Schallwellen gewährleistet.

9. Schallwellen-Bandpassfilter nach einem der vorherigen Ansprüche, **dadurch gekennzeichnet, dass** die erste phononische Kristallstruktur eine Schallwellenkopplungsstruktur ist und der Schallwellenübertragungskoeffizient der zweiten phononischen Kristallstrukturen viel kleiner ist als der der ersten phononischen Kristallstrukturen.

10. Schallwellen-Bandpassfilter nach einem der vorherigen Ansprüche, **dadurch gekennzeichnet, dass** es mindestens einen Eingangsresonator, verbunden mit einem ersten Potential (V1) und mit Masse, einen ersten Ausgangsresonator, verbunden mit einem zweiten Potential (+V2) und mit Masse, umfasst, und einen zweiten Ausgangsresonator, verbunden mit der Umkehr des zweiten Potentials (-V2) und mit Masse, um eine Konvertierung von Impedanz und akustischen Moden zwischen dem Eingangsresonator und den Ausgangsresonatoren zu gewährleisten.

11. Schallwellen-Bandpassfilter nach einem der Ansprüche 1 bis 10, **dadurch gekennzeichnet, dass** sich die phononischen Kristallstrukturen in der piezoelektrischen oder elektrostriktiven Materialschicht befinden.

12. Schallwellen-Bandpassfilter nach einem der Ansprüche 1 bis 11, **dadurch gekennzeichnet, dass** die phononischen Kristallstrukturen (CP$_1$, CP$_2$) Muster auf der Oberfläche der piezoelektrischen oder elektrostriktiven Materialschicht aufweisen.

**13.** Schallwellen-Bandpassfilter nach Anspruch 12, **dadurch gekennzeichnet, dass** die Muster der phononischen Strukturen (CP1 oder CP2) mit mindestens einem der folgenden Materialien realisiert werden: $SiO_2$, SiN, Mo, W, AlN.

**14.** Schallwellen-Bandpassfilter nach einem der Ansprüche 1 bis 13, **dadurch gekennzeichnet, dass** die phononischen Kristallstrukturen eindimensional oder zweidimensional oder auch dreidimensional sind.

**15.** Schallwellen-Bandpassfilter nach einem der Ansprüche 1 bis 14, **dadurch gekennzeichnet, dass** das piezoelektrische Material ein Material aus AlN, $LiNbO_3$, ZnO, PZT, Quarz ist.

**16.** Schallwellen-Bandpassfilter nach einem der Ansprüche 1 bis 14, **dadurch gekennzeichnet, dass** das elektrostriktive Material ein Material ausgewählt aus $BaSrTiO_3$, $SrTiO_3$, $BaTiO_3$ ist.

**17.** Schallwellen-Bandpassfilter nach einem der vorherigen Ansprüche, **dadurch gekennzeichnet, dass** die phononischen Kristallstrukturen atomare Einschlüsse und/oder diffuse Spezies umfassen.

**18.** Schallwellen-Bandpassfilter nach Anspruch 17, **dadurch gekennzeichnet, dass** die Einschlüsse durch Implantation von Wasserstoffatomen erhalten werden.

**19.** Schallwellen-Bandpassfilter nach einem der vorherigen Ansprüche, **dadurch gekennzeichnet, dass** die phononischen Kristallstrukturen Löcher umfassen.

**20.** Schallwellen-Bandpassfilter nach einem der Ansprüche 1 bis 19, **dadurch gekennzeichnet, dass**, da das Filter mehrere erste phononische Kristallstrukturen umfasst, bestimmte der ersten Strukturen ($CP_1$) Schallwellen-Dämpfungskoeffizienten aufweisen, die sich von denen der anderen ersten Strukturen unterscheiden.

**Claims**

**1.** An acoustic wave bandpass filter comprising at least an input first acoustic wave resonator ($R_{1E}$) with an output surface, and an output second acoustic wave resonator ($R_{2S}$) with an input surface, said resonators being acoustically coupled to each other, the input and output surfaces being substantially opposite, **characterized in that** it furthermore comprises at least one first phononic crystal structure ($CP_1$) between said input and output resonators to control the amount of energy exchanged between the two resonators and a second phononic crystal structure ($CP_2$) at the periphery of said resonators so as to guide the acoustic waves, generated by said input resonator, toward said output resonator, the resonators:

- comprising at least one layer of piezoelectric material ($P_{iezo}$) or of electrostrictive material, and at least one electrode;
- being bulk wave resonators,
- being placed side by side on the same substrate,
- ensuring an impedance conversion and/or mode conversion.

**2.** The bandpass filter as claimed in claim 1, **characterized in that** the input and output surfaces of said respective second and first resonators are parallel to each other.

**3.** The acoustic wave bandpass filter as claimed in one of claims 1 or 2, **characterized in that** said output surface of said input resonator has a different dimension from that of said input surface of said output resonator.

**4.** The acoustic wave bandpass filter as claimed in one of claims 1 to 3, **characterized in that** it comprises a first set of input resonators ($R_{iE}$) and a second set of output resonators ($R_{iS}$), a first phononic crystal structure ($CP_1$) being placed between said first set and said second set.

**5.** The acoustic wave bandpass filter as claimed in claim 4, **characterized in that** it comprises a resonator from one of said sets being coupled with two resonators of said other set.

**6.** The acoustic wave bandpass filter as claimed in one of claims 1 to 4, **characterized in that** it comprises more than one set of input resonators coupled to second output resonators, a first phononic crystal structure ($CP_1$) being placed between a first input resonator and a second output resonator.

**7.** The acoustic wave bandpass filter as claimed in one of claims 3 to 6, **characterized in that** the first phononic crystal structure ($CP_1$) is an acoustic lens structure.

**8.** The acoustic wave bandpass filter as claimed in one of claims 1 to 7, **characterized in that** the second phononic crystal structure ($CP_2$) ensures a mirror function for said acoustic waves.

**9.** The acoustic wave bandpass filter as claimed in one of the preceding claims, **characterized in that** the first phononic crystal structure is an acoustic wave coupling structure, and the acoustic wave transmission coefficient of the second phononic crystal structures is much smaller than that of the first phononic crystal structures.

10. The acoustic wave bandpass filter as claimed in one of the preceding claims, **characterized in that** it comprises at least one input resonator connected to a first potential (V1) and to ground, a first output resonator connected to a second potential (+V2) and to ground, and a second output resonator connected to the inverse of the second potential (-V2) and to ground, so as to ensure an impedance conversion and an acoustic mode conversion between the input resonator and the output resonators.

11. The acoustic wave bandpass filter as claimed in one of claims 1 to 10, **characterized in that** the phononic crystal structure is located inside the layer of piezoelectric or electrostrictive material.

12. The acoustic wave bandpass filter as claimed in one of claims 1 to 11, **characterized in that** the phononic crystal structure ($CP_1$, $CP_2$) comprises features on the surface of the layer of piezoelectric or electrostrictive material.

13. The acoustic wave bandpass filter as claimed in claim 12, **characterized in that** the features of the phononic structures (CP1 or CP2) are produced with at least one of the following materials: $SiO_2$, SiN, Mo, W, AlN.

14. The acoustic wave bandpass filter as claimed in one of claims 1 to 13, **characterized in that** the phononic crystal structures are one-dimensional or two-dimensional or even three-dimensional.

15. The acoustic wave bandpass filter as claimed in one of claims 1 to 14, **characterized in that** the piezoelectric material is a material chosen from AlN, $LiNbO_3$, ZnO, PZT and quartz.

16. The acoustic wave bandpass filter as claimed in one of claims 1 to 14, **characterized in that** the electrostrictive material is a material chosen from $BaSrTiO_3$, $SrTiO_3$ and $BaTiO_3$.

17. The acoustic wave bandpass filter as claimed in one of the preceding claims, **characterized in that** the phononic crystal structures comprise atomic inclusions and/or diffused species.

18. The acoustic wave bandpass filter as claimed in claim 17, **characterized in that** the inclusions are obtained by implanting hydrogen atoms.

19. The acoustic wave bandpass filter as claimed in one of the preceding claims, **characterized in that** the phononic crystal structures comprise holes.

20. The acoustic wave bandpass filter as claimed in one of claims 1 to 19, **characterized in that**, said filter comprising a plurality of first phononic crystal structures, certain of said first structures ($CP_1$) have acoustic wave attenuation coefficients that are different from those of the other first structures.

FIG.1

FIG.2a

FIG.2b

FIG.3

FIG.4

FIG.5

FIG.6

FIG.7

20log(|Y|)

FIG.8

FIG.9a

FIG.9b

FIG.9c

FIG.10a

FIG.10b

FIG.10c

FIG.10d

FIG.10e

FIG.11a

**FIG.11b**

**FIG.11c**

**FIG.11d**

**FIG.11e**

**FIG.11f**

FIG.12a

FIG.12b

FIG.12c

FIG.12d

FIG.12e

FIG.12f

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090096549 A1
- US 20090273415 A1
- US 2009295505 A
- US 6492759 B

- US 20050140465 A
- US 20090295505 A1, S. Mohammadi, A.A. Eftekhar, A. Adibi

**Littérature non-brevet citée dans la description**

- **G.G. FATTINGER ; J. KAITILA ; R. AIGNER ; W. NESSLER.** Single-to-balanced Filters for Mobile Phones using Coupled Resonator BAW Technology. *2004 IEEE Ultrasonics Symposium,* 416-419
- **C. BILLARD ; N. BUFFET ; A. REINHARDT ; G. PARAT ; S. JOBLOT ; P. BAR.** 200mm Manufacturing Solution for Coupled Resonator Filters. *Proceedings of the 39th European Solid-State Device Research Conference (ESSDERC,* 2009, 133-136
- **ROY.H.OLSSON III ; IHAB F.EL-KADY ; MEHMET F.SU ; MELANIE R.TUCK ; JAMES G.FLEMING.** Microfabricated VHF acoustic crystals and waveguides. *ScienceDirect Sensors and Actuators A,* 2008, vol. 145-146, 87-93

- **G. PIAZZA ; N.K. KUO ; C.J. ZUO ; G. PIAZZA.** Demonstration of Inverse Acoustic Band Gap Structures in AIN and Integration with Piezoelectric Contour Mode Wideband Transducers. *2009 Solid-State Sensors, Actuators and Microsystems symposium,* 2009, 10-13
- **N. SINHA ; R. MAHAMEED ; C. ZUO ; M.B. PISANI ; C.R. PEREZ ; G. PIAZZA.** Dual-beam actuation of piezoelectric AIN RF MEMS switches monolithically integrated with AIN contour-mode resonators, Solid-State Sensors. *Actuators and Microsystems Workshop,* 01 Juin 2008, 22-25